# EUROPEAN PATENT APPLICATION

(11) **EP 4 465 341 A1**
(43) Date of publication of application: **20.11.2024**
(21) Application number: 22920419.3
(22) Date of filing: 27.10.2022
(51) Int. Cl.: H01L 21/301, B23K 26/03, B23K 26/08, B23K 26/10, B23K 26/38, H01L 21/683

(54) **PROCESSING DEVICE AND METHOD FOR MANUFACTURING PROCESSED ARTICLE**

(30) Priority: 11.01.2022 JP 2022002378
(71) Applicant: Towa Corporation, Kyoto-shi, Kyoto 601-8105 (JP)
(72) Inventor: OKAMOTO, Jun, Kyoto-shi, Kyoto 601-8105 (JP)
(74) Representative: Müller Hoffmann & Partner
(86) International application number: PCT/JP2022/040133
(87) International publication number: WO 2023/135897

(57) **Abstract**

The present invention is to simplify a machining apparatus and to improve the productivity by capturing an image of a workpiece having been machined and inspecting the workpiece having been machined while the workpiece is being suctioned on a machining table, and includes: a machining table 2A, 2B having one surface provided with a plurality of suction holes 2h enabled to suction a sealed substrate W; a machining mechanism 4 that machines the sealed substrate W being suctioned onto the machining table 2A, 2B; and a first camera 131 that captures an image of the sealed substrate W having been machined by the machining mechanism 4. The machining table 2A, 2B has a plurality of through openings 2T penetrating the machining table from the one surface 2x to the other surface 2y. The machining mechanism 4 machines the sealed substrate W in each of the through openings 2T, and the first camera 131 captures an image of the sealed substrate W having been machined while the sealed substrate W is being suctioned on the machining table 2A, 2B.

## Description

### Technical Field

The present invention relates to a machining apparatus and a method for manufacturing machined articles.

### Background Art

Conventionally having been thought up is a substrate cutting apparatus including a first package picking mechanism that transports molded substrates (packages) having been cut, from a cutting table to a reverse holder plate, and a camera for capturing an image of the packages and inspecting the packages while the packages are being suctioned on the reverse holder plate, as disclosed in Patent Literature 1.

### Citation List

### Patent Literature

Patent Literature 1: JP 2009-130342 A

### Summary of Invention

### Technical Problem

However, such a cutting apparatus has a complicated structure because the cutting apparatus requires a reverse inspection plate for inspecting the packages, and a transport mechanism (first package picking mechanism) for transporting the packages from the cutting table to the reverse holder plate. Furthermore, the time required in transporting the packages from the cutting table to the reverse holder plate becomes a limitation in improving the productivity.

The present invention has been made to solve the problems described above, and a main object of the present invention is to simplify a machining apparatus and to improve the productivity of the machining apparatus, by capturing an image of a workpiece having been machined and inspecting the workpiece having been machined while the workpiece is being suctioned onto the machining table.

### Solution to Problem

That is, a machining apparatus according to the present invention includes: a machining table having one surface provided with a plurality of suction holes enabled to suction a workpiece; a machining mechanism that machines the workpiece being suctioned onto the machining table; and a first camera that captures an image of the workpiece having been machined by the machining mechanism, in which: the machining table has a plurality of through openings penetrating the machining table from the one surface to another surface; the machining mechanism machines the workpiece in each of the through openings; and the first camera captures an image of the workpiece having been machined while the workpiece is being suctioned on the machining table.

### Advantageous Effect of Invention

According to the present invention configured as described above, it is possible to simplify a machining apparatus and to improve productivity by capturing an image of a workpiece having been machined and inspecting the workpiece having been machined while the workpiece is being suctioned onto the machining table.

### Brief Description of Drawings

FIG. 1 is a plan view illustrating an example of a workpiece (sealed substrate).
FIG. 2 is a diagram schematically illustrating a configuration of a cutting apparatus (tray storage) according to an embodiment of the present invention.
FIG. 3 is a perspective view illustrating a cutting table and a table reversing mechanism according to the embodiment.
FIG. 4 is a cross-sectional view passing through the suction holes in the cutting table and the table reversing mechanism according to the embodiment.
FIG. 5 is a plan view illustrating positional relationships between through openings, the suction holes, and a suction channel according to the embodiment.
FIG. 6 is an enlarged exploded perspective view of a part of the cutting table according to the embodiment.
FIG. 7(a) is an enlarged cross-sectional view of a part of the cutting table according to the embodiment, along a direction orthogonal to the direction in which a laser beam is scanned, and FIG. 7(b) is an enlarged cross-sectional view of a part of the cutting table along the direction in which a laser beam is scanned.
FIG. 8 is a schematic diagram illustrating the sequence of laser cutting and swarf removal according to the embodiment.
FIG. 9 is a schematic diagram illustrating the direction along which a first camera captures images in the embodiment.
FIG. 10 is a schematic diagram illustrating the sequence in which the first camera captures images and swarf is removed again, according to the embodiment.
FIG. 11 is a schematic diagram illustrating the sequence in which the products are transferred from the cutting table to a second pickup mechanism according to the embodiment.
FIG. 12 is a diagram schematically illustrating a configuration of a cutting apparatus (tube storage) according to a modification of the embodiment.
FIG. 13(a) is a perspective view, and FIG. 13(b) is a cross-sectional view schematically illustrating a configuration of a tubular container.
FIG. 14 is a diagram schematically illustrating a configuration of a cutting apparatus (ring storage) according to a modification of the embodiment.
FIG. 15(a) is a plan view, FIG. 15(b) is a cross-sectional view, and FIG. 15(c) is a partially enlarged cross-sectional view schematically illustrating a configuration of a bonding member.

### Description of Embodiment

The present invention will now be explained more in detail using some examples. However, the following description is not intended to limit the scope of the present invention in any way.

As described above, a machining apparatus according to the present invention includes: a machining table having one surface provided with a plurality of suction holes enabled to suction a workpiece; a machining mechanism that machines the workpiece being suctioned onto the machining table; and a first camera that captures an image of the workpiece having been machined by the machining mechanism, in which: the machining table has a plurality of through openings penetrating the machining table from the one surface to another surface; the machining mechanism machines the workpiece in each of the through openings; and the first camera captures an image of the workpiece having been machined while the workpiece is being suctioned on the machining table.

With this machining apparatus, because the first camera captures an image of the machined workpiece being suctioned onto the machining table, it is not necessary to transfer the machined workpiece to a separate inspection table, and it is possible to simplify and to improve the productivity of the machining apparatus having a function of inspecting the machined workpiece. In addition, by performing the inspection while moving the first camera relatively with respect to the machining table, it is possible to reduce the number of stops, accelerations, and decelerations of the machining table and to shorten the inspection time. Furthermore, because the machining apparatus can be simplified, the footprint can be reduced.

Preferably, the machining apparatus further includes an actuator mechanism that moves the first camera and the machining table relatively with respect to each other, for the purpose of allowing the first camera to capture an image of the machined workpiece being suctioned onto the machining table.

With this configuration, it is possible to inspect the workpiece having been machined, at a position not interfering with the machining operation of the machining mechanism. In other words, the first camera does not interfere with the machining operation of the machining mechanism.

In order to facilitate capturing of an image of a portion removed by the machining mechanism (kerf) and to improve the accuracy of the inspection, the actuator mechanism preferably moves the first camera and the machining table relatively to each other along a direction along which the machining mechanism performs machining.

Preferably, the machining apparatus further include a back-surface side illumination unit that is provided on the opposite side of the first camera with respect to the machining table, and generates transmitting light that is to pass through the through openings.

With this configuration, by capturing an image of the transmitting light passed through the through openings, it is possible to check whether there is any swarf remaining between the machined workpieces, easily. In addition, it is possible to make an accurate measurement of the minimum width of the kerf between the machined workpieces.

In order to inspect the external shape on the front-surface side of the workpiece having been machined, e.g., to inspect the shape of the kerf such as the kerf width, accurately, the machining apparatus according to the present invention preferably further includes a front-surface side illumination unit that is provided on the same side as the first camera with respect to the machining table, and that illuminates the workpiece having been machined.

In this configuration, in order to inspect the shape of the kerf such as the kerf width between the machined workpieces from both of the front-surface side and the back-surface side, efficiently, the first camera preferably captures an image of the machined workpiece, while turning on the front-surface side illumination unit and the back-surface side illumination unit alternately.

Preferably, the machining apparatus according to the present invention further includes a swarf removing mechanism that removes swarf remaining on the workpiece having been machined.

With this configuration, when the swarf is detected by the inspection in which the first camera is caused to capture an image, the remaining swarf can be removed by the swarf removing mechanism. The inspection in which the first camera is caused to capture an image may also be performed after the remaining swarf is removed by the swarf removing mechanism, as a confirmation.

Preferably, the machining apparatus according to the present invention further includes: a transport mechanism that transports the workpiece having been machined, by suctioning a surface on an opposite side of a suctioned surface that is suctioned by the machining table; and a second camera that captures an image of the suctioned surface of the workpiece being transported by the transport mechanism.

With this configuration, it is possible to inspect the suctioned surface (back surface) of the workpiece having been machined, the suctioned surface being a surface where the inspection by the first camera falls short, while the workpiece having been machined is being transported from the machining table. In addition, because the inspection is performed during the transportation, the simplification of the structure and the improvement in the productivity of the machining apparatus are not obstructed.

As a specific embodiment of the machining mechanism, the workpiece is preferably cut by irradiating the workpiece with a laser beam.

Preferably, the machining table is enabled to be turned over, and the workpiece is cut from both sides by turning over the machining table with the workpiece being suctioned thereto, and by irradiating the workpiece with the laser beam.

With this configuration, by turning over the machining table with the workpiece suctioned thereto, the workpiece can be machined from both sides of the workpiece. Therefore, it is possible to reduce the machining time, and to improve the productivity.

In addition, because the machining table is turned over (turned upside down) while the machining table is holding the workpiece, by collecting a measurement of the amount of the positional shift resultant of turning over the machining table once in advance, it becomes possible to correct the position after the reversal through calculation. Therefore, it is not necessary to make the alignment (adjust the position) every time a workpiece is turned over. Therefore, the alignment (positional adjustment) of the laser beam output unit with respect to the workpiece is required only once after the workpiece is suctioned, and this also contributes in the reduction in the machining time and improvement in the productivity.

In addition, when the workpiece is irradiated and cut with a laser beam, because the laser beam passes through the through opening, the laser beam can be prevented from hitting the machining table. As a result, it is possible to suppress damages of the machining table, resultant of being irradiated with a laser beam, to lessen the contaminants (impurities, foreign matters) becoming adhered to the workpiece due to the damages, and to alleviate the restrictions imposed on laser machining conditions for preventing damages of the machining table. Because the restrictions imposed on the laser machining conditions can be alleviated, it becomes possible to use higher pulse energy and average output. Therefore, it is possible to shorten the machining time and to improve productivity, advantageously.

In addition, because the laser beam passes through the through opening, it is possible to prevent the laser beam from becoming reflected on the machining table, and causing the workpiece to be irradiated therewith; therefore, it is also possible to suppress damages of the workpiece, resultant of the laser beam reflected on the machining table.

A method for manufacturing a machined article using the machining apparatus is also one aspect of the present invention.

As a specific embodiment of the method for manufacturing a machined article, the method preferably includes: a cutting step of turning over a machining table holding the workpiece and cutting the workpiece by irradiating both surfaces of the workpiece with a laser beam; and an inspection step of inspecting the workpiece having been machined, the workpiece being suctioned on the machining table, by causing the first camera to capture an image of the workpiece.

Because the workpiece is cut by turning over the machining table and irradiating both sides of the workpiece with a laser beam, it is not necessary to transfer the workpiece to turn over the workpiece. Therefore, the machining time such as that required in cutting is reduced, and the productivity is improved. In addition, because the workpiece is machined from both sides, it is possible to reduce the depth by which the workpiece is machined from one side. Therefore, it is possible to make the required kerf width smaller. As a result, the number of laser scanning lines can reduced, and the productivity is improved. Furthermore, it becomes possible to reduce the pitch size between the packages of the workpiece. Therefore, it becomes possible to use a layout with a larger number of packages, so that the number of packages per frame is increased and the productivity is improved, accordingly. Furthermore, by performing machining from both sides, it is possible to alleviate the tapered shape resultant of laser machining, so that the quality is also improved.

### <One embodiment of present invention>

A machining apparatus according to one embodiment of the present invention will now be explained with reference to some drawings. Note that, to facilitate understanding, all of the drawings described below are schematic representations, with some omissions and exaggerations made as appropriate. The same elements are denoted by the same reference numerals, and the descriptions thereof will be omitted as appropriate.

### <Overall configuration of machining apparatus>

A machining apparatus 100 according to this embodiment is a cutting apparatus for cutting a sealed substrate W, which is a workpiece, to dice the sealed substrate W into a plurality of products P that are cut articles.

The sealed substrate W is a support body having at least electronic elements fixed thereto, such as semiconductor chips, resistor elements, and capacitor elements, sealed with resin. As the support body, it is possible to use a lead frame or a substrate such as a printed wiring board, as well as a semiconductor substrate (including a semiconductor wafer such as a silicon wafer), a metal substrate, a ceramic substrate, a glass substrate, or a resin substrate. The substrate of the sealed substrate W may include or not include wiring.

One surfaces of the sealed substrate W and the products P according to this embodiment serve as mounting surfaces to be mounted in a subsequent process. In the description of this embodiment, the one surface to be mounted in the subsequent process will be referred to as a "mounting surface", and the surface on the opposite side of the mounting surface will be referred to as a "mark surface".

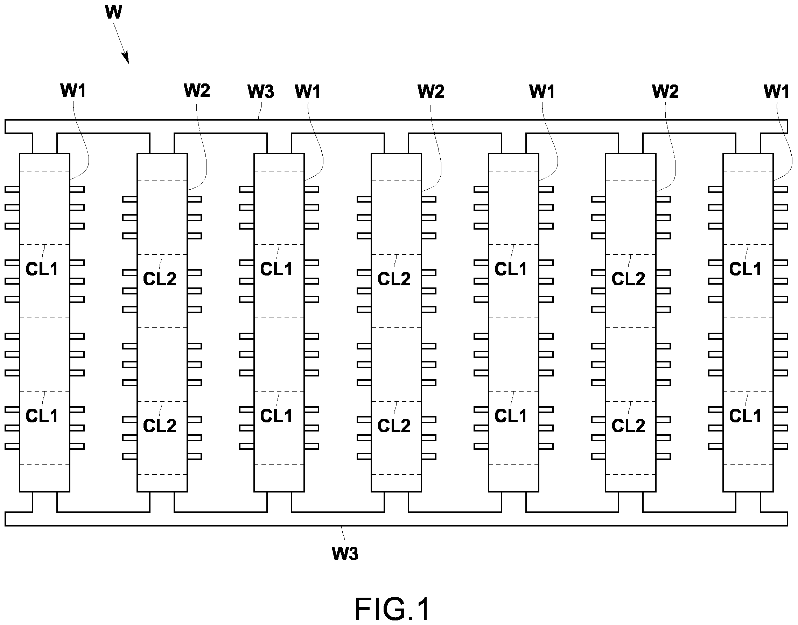

As illustrated in FIG. 1, the sealed substrate W includes a plurality of strips W1, W2 that are connected by a connector W3. The adjacent strips W1, W2 have cut lines CL1, CL2, respectively, that are set along the straight lines that are offset from each other, respectively. Each of the strips W1, W2 is an arrangement of a plurality of packages arranged in a row, each package including an electronic element that is resin-molded and sealed thereby. Each of such packages (electronic elements) has leads corresponding thereto. The connectors W3 connect the respective ends of the plurality of strips W1, W2. Specifically, the leads of the strips W1 at the odd-numbered columns and those in the strips W2 at the even-numbered columns are disposed in a staggered fashion. As a result, the cut lines CL1 on the strips W1 at the odd-numbered columns are aligned along the same lines, respectively. The cut lines CL2 on the strips W2 at the even-numbered columns are aligned with the same lines, respectively. The cut lines CL1 on the strips W1 at the odd-numbered columns are aligned along the lines that are offset from those along which the cut lines CL2 on the strips W2 at the even-numbered columns are aligned. Note that the cut lines CL1, CL2 illustrated in FIG. 1 are virtual lines to be cut, and are not marked on the actual sealed substrates W.

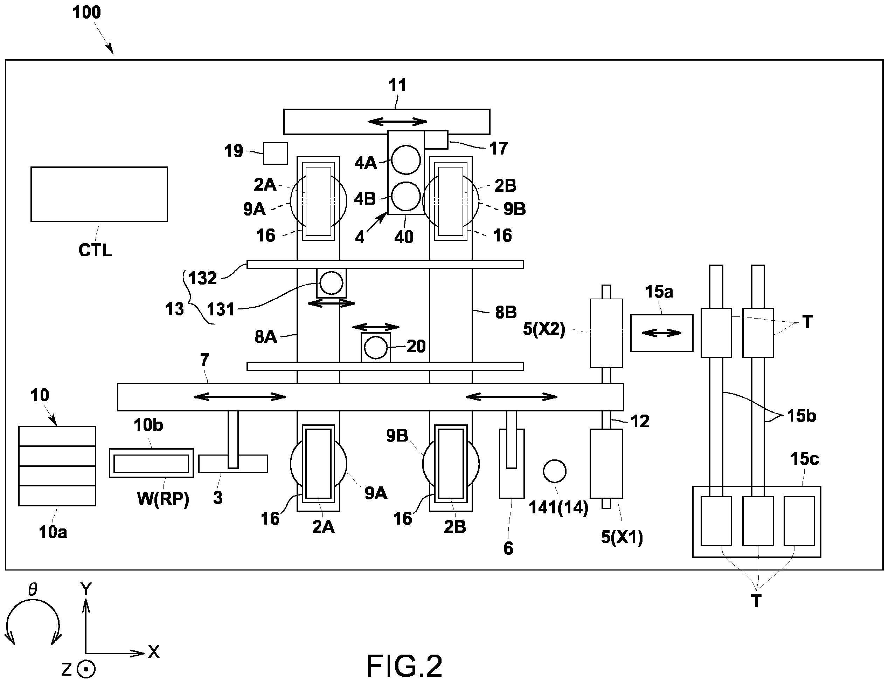

Specifically, as illustrated in FIG. 2, the cutting apparatus 100 includes: two cutting tables 2A, 2B each of which holds a sealed substrate W; a first pickup mechanism 3 that picks up a sealed substrate W to be transported onto the cutting table 2A, 2B; a cutting mechanism 4 that cuts the sealed substrates W on the cutting table 2A, 2B; a transfer table 5 onto which a plurality of products P are transferred; a second pickup mechanism 6 that picks up the plurality of products P, and transfers the plurality of products P from the cutting table 2A, 2B onto the transfer table 5; and a transport actuator mechanism 7 that moves the first pickup mechanism 3 and the second pickup mechanism 6. Note that the first pickup mechanism 3 and the transport actuator mechanism 7 makes up a transport mechanism (loader) that transfers a sealed substrate W, and the second pickup mechanism 6 and the transport actuator mechanism 7 together make up a transport mechanism (unloader) that transfers the plurality of products P.

In the description hereunder, directions orthogonal to each other on a plane extending along the top surfaces of the cutting tables 2A, 2B (horizontal plane) are defined as an X direction and a Y direction, and a vertical direction orthogonal to the X direction and the Y direction is defined as a Z direction. Specifically, the horizontal direction and the vertical direction in FIG. 2 are defined as the X direction (first direction) and the Y direction (second direction), respectively.

### <Cutting tables 2A, 2B>

The two cutting tables 2A, 2B are configured to suction and hold the sealed substrate W, and are provided in a manner movable at least in the Y direction. The cutting table 2A is enabled to move in the Y direction by a cutting actuator mechanism 8A, and is enabled to rotate in the θ direction by a rotating mechanism 9A. The cutting table 2B is enabled to move in the Y direction by a cutting actuator mechanism 8B, and is enabled to rotate in the θ direction by a rotating mechanism 9B. Specific configurations of the cutting tables 2A, 2B will be described later.

### <First pickup mechanism 3>

As illustrated in FIG. 2, the first pickup mechanism 3 picks up a sealed substrate W to transport the sealed substrate W from a substrate feeder mechanism 10 onto the cutting tables 2A, 2B. The first pickup mechanism 3 includes a plurality of suction portions (not illustrated) for suctioning and holding the sealed substrates W. By moving the first pickup mechanism 3 to a desired position using the transport actuator mechanism 7 to be described later, for example, sealed substrates W are transported from the substrate feeder mechanism 10 to the cutting tables 2A, 2B.

As illustrated in FIG. 2, the substrate feeder mechanism 10 includes a substrate housing 10a where a plurality of sealed substrates W from outside are stored, and a substrate feeder unit 10b that moves the sealed substrate W from the inside of the substrate housing 10a to a pickup position RP where the first pickup mechanism 3 suctions to pick up the sealed substrate W.

### <Cutting mechanism 4>

As illustrated in FIG. 2, the cutting mechanism 4 is configured to irradiate the sealed substrate W suctioned to the cutting tables 2A, 2B with a laser beam to cut the sealed substrate W, and includes two laser beam output units 41A, 41B.

The two laser beam output units 41A, 41B are provided along the Y direction, and are enabled to output laser beams independently. Each of the laser beam output units 41A, 41B includes a laser oscillator, a laser beam scanning unit such as a galvano scanner that linearly scans the laser from the laser oscillator, and a condenser lens that condenses the laser beam. In each of the laser beam output units 41A, 41B, the laser beam is condensed by the condenser lens on the sealed substrate W suctioned to the cutting tables 2A, 2B, and the sealed substrate W suctioned to the cutting tables 2A, 2B is linearly scanned by the laser beam scanning unit.

In the present embodiment, the two laser beam output units 41A, 41B are provided to a single machining head 40, and the machining head 40 is enabled to move between the two cutting tables 2A, 2B along the X direction, by the machining head actuator mechanism 11. The machining head actuator mechanism 11 can also move the machining head 40 in the Y direction and the Z direction. The two laser beam output units 41A, 41B may also be configured to be movable at least in the X direction or the Y direction with respect to the machining head 40. Note that the two laser beam output units 41A, 41B may be configured to be independently movable between the two cutting tables 2A, 2B.

To cut on the cutting table 2A, the cutting table 2A and the two laser beam output units 41A, 41B are moved relatively to each other to scan the laser beam, and the sealed substrate W is cut and diced thereby. To cut on the cutting table 2B, the cutting table 2B and the two laser beam output units 41A, 41B are moved relatively to each other to scan the laser beam, and the sealed substrate W is cut and diced thereby. Note that the cutting process on the cutting table 2A and the cutting process on the cutting table 2B can be performed alternatingly.

### <Transfer table 5>

As illustrated in FIG. 2, the transfer table 5 according to this embodiment is a table to which a plurality of products P having been inspected by a first inspection unit 13 and a second inspection unit 14 are transferred. Specific configurations of the first inspection unit 13 and the second inspection unit 14 will be described later.

The transfer table 5 is what is called an indexing table, and a plurality of products P are placed thereon temporarily, before the plurality of products P are sorted and stored on various trays T. The transfer table 5 is also provided in a manner movable back and forth in the Y direction. The transfer table 5 is then moved, by a transfer actuator mechanism 12, between a transfer position X1 where the plurality of products P are placed by the second pickup mechanism 6, and a pickup position X2 where the plurality of products P are transported by the sorting mechanism 15a.

A sorting mechanism 15a then sorts the plurality of products P from the transfer table 5 onto the various trays T, based on the results of the inspections (e.g., non-defective products and defective products) carried out by the first inspection unit 13 and the second inspection unit 14. The various trays T are transferred, by a tray actuator mechanism 15b, from a tray storage 15c to a desired pickup position X2, where products P sorted by the sorting mechanism 15a are placed. The tray actuator mechanism 15b then stores various trays T having the products sorted thereon in the tray storage 15c. In the present embodiment, the tray storage 15c is configured to store three types of trays T, for example, a tray T before the products P are stored, a tray T storing therein non-defective product P, and a tray T storing therein the defective products P that requires rework.

### <Second pickup mechanism 6>

As illustrated in FIG. 2, the second pickup mechanism 6 picks up a plurality of products P to transfer the plurality of products P from the cutting table 2A, 2B to the transfer table 5. The second pickup mechanism 6 suctions the surface (mounting surface) on the opposite side of the suctioned surface, which is suctioned by the cutting table 2A, 2B. The second pickup mechanism 6 includes a plurality of suction portions (not illustrated) for suctioning and holding the plurality of products P. The second pickup mechanism 6 is then moved to a desired position by the transport actuator mechanism 7, which will be described later, for example, to transport the plurality of products P from the cutting table 2A, 2B onto the transfer table 5.

### <Transport actuator mechanism 7>

As illustrated in FIG. 2, the transport actuator mechanism 7 moves the first pickup mechanism 3 at least between the substrate feeder mechanism 10 and the cutting table 2A, 2B, and moves the second pickup mechanism 6 at least between the cutting table 2A, 2B and the transfer table 5.

As illustrated in FIG. 2, the transport actuator mechanism 7 extends in a straight line along the direction in which the two cutting tables 2A, 2B and the transfer table 5 are arranged (X direction), and includes the shared transfer shaft 71 for moving the first pickup mechanism 3 and the second pickup mechanism 6. The transfer shaft 71 is provided across a range allowing the first pickup mechanism 3 to move above the substrate feeder unit 10b of the substrate feeder mechanism 10, and allowing the second pickup mechanism 6 to move above the transfer table 5 (see FIG. 2). Note that the transfer shaft 71 may be provided individually for each of the first pickup mechanism 3 and the second pickup mechanism 6.

The transport actuator mechanism 7 is enabled to move the first pickup mechanism 3 and the second pickup mechanism 6 in each of the X direction and the Z direction with respect to the transfer shaft 71. As actuator mechanisms for moving in these directions, an actuator mechanism using a rack and pinion mechanism, a ball screw mechanism, an air cylinder, or a linear motor, for example, may be used.

### <Specific configuration of cutting tables 2A, 2B>

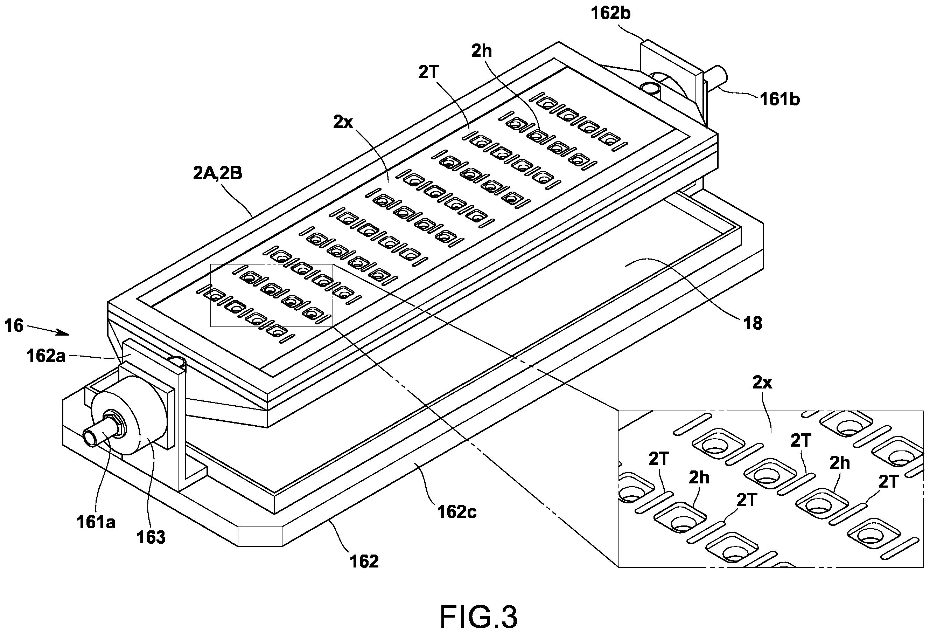

Specific configurations of the cutting tables 2A, 2B will now be described with reference to FIGS. 3 to 8.

### <Suctioning function of cutting tables 2A, 2B>

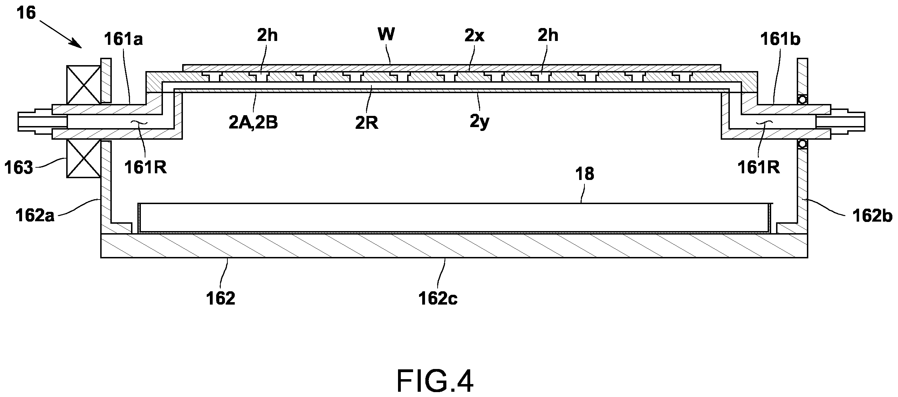

As illustrated in FIGS. 3 and 4, each of the cutting tables 2A, 2B is provided with a plurality of suction holes 2h through which the sealed substrate W can be suctioned, on one surface 2x. The plurality of suction holes 2h communicate with a suction channel 2R formed inside the cutting table 2A, 2B. The suction channel 2R is connected to a vacuum pump, not illustrated.

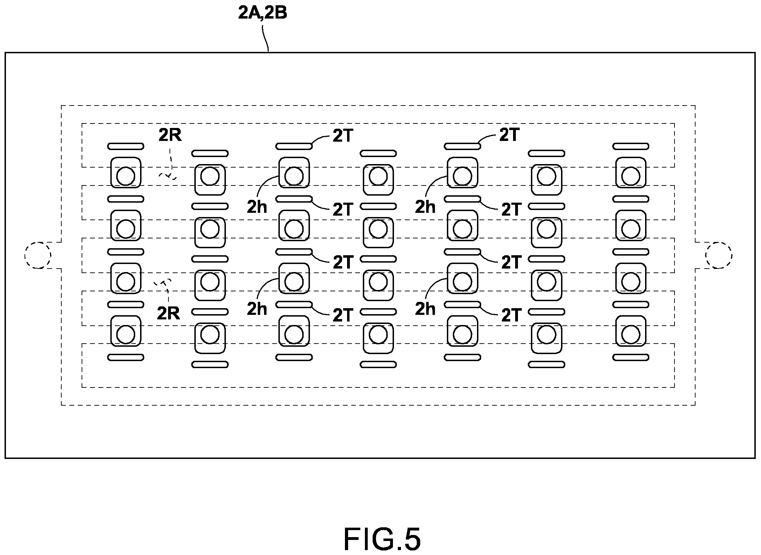

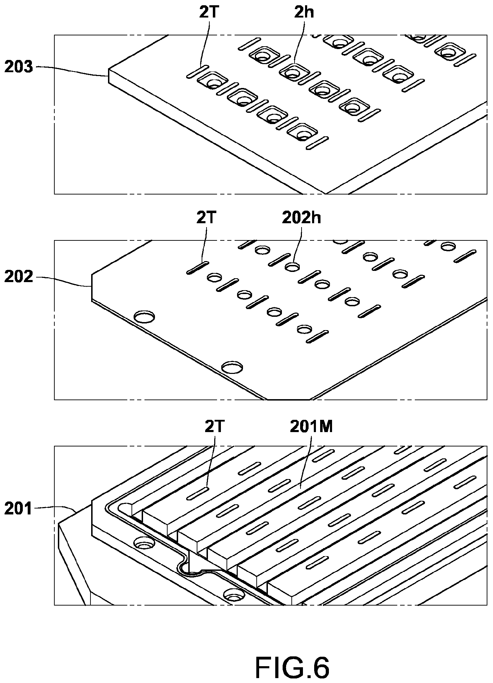

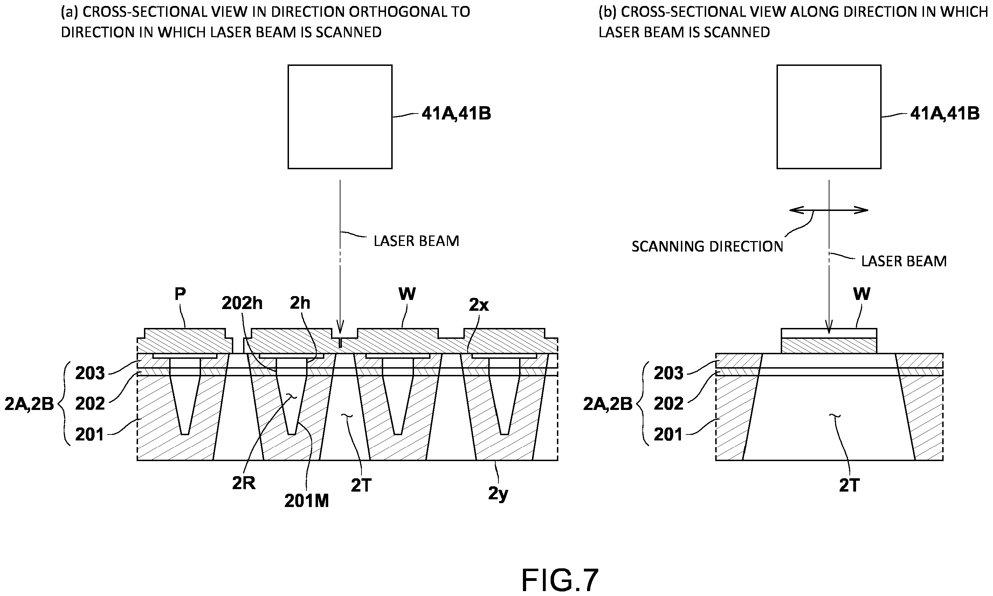

Specifically, as illustrated in FIG. 5, each of the cutting tables 2A, 2B has a substantially rectangular shape in a plan view. As illustrated in FIGS. 6 and 7, each of the cutting tables 2A, 2B includes: a base plate 201 that has grooves 201M forming the suction channel 2R, on the top surface of the base plate 201; a cover plate 202 that is provided on the top surface of the base plate 201 in a manner closing the grooves 201M, and that has suction through holes 202h communicating with the grooves 201M; and a suction rubber 203 that is made of resin and that is bonded to the top surface of the cover plate 202, and that has the suction holes 2h communicating with the suction through holes 202h, respectively. This suction rubber 203 prevents damages of the sealed substrate W and leakage, and enables the sealed substrate W to be fixed firmly, when the sealed substrate W is suctioned. The top surface of the suction rubber 203 serves as the one surface 2x of the cutting tables 2A, 2B, and the bottom surface of the base plate 201 serves as the other surface 2y of the cutting tables 2A, 2B.

### <Function for reversing cutting tables 2A, 2B>

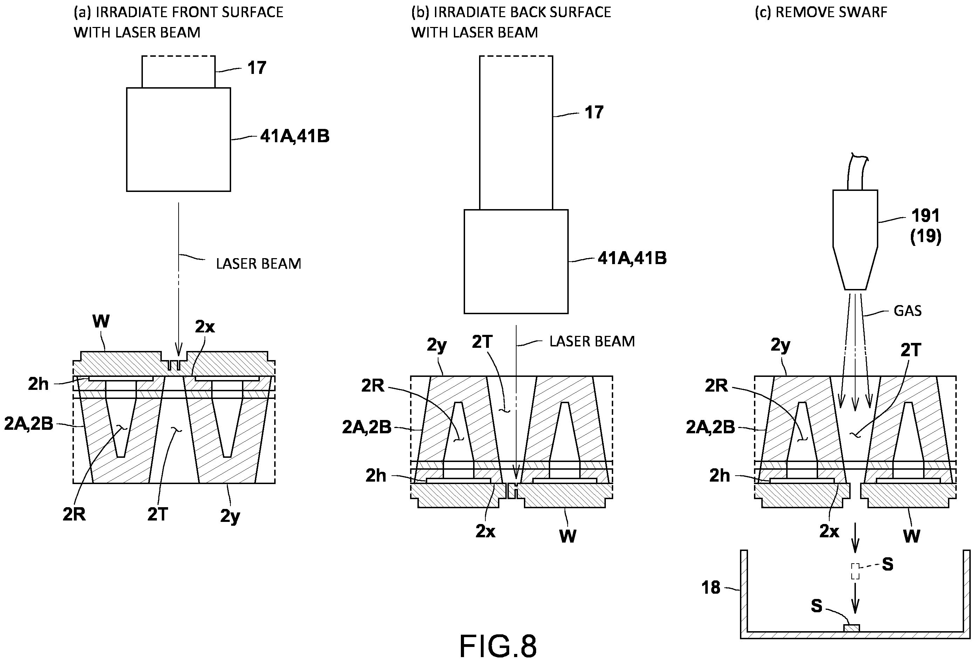

As illustrated in FIGS. 3 and 4, each of the cutting tables 2A, 2B is enabled to be turned over by a table reversing mechanism 16. The cutting table 2A, 2B is thus configured switchable between a configuration having one surface 2x facing upwards (facing the laser beam output unit 41A, 41B) (see FIG. 8(a)) and a configuration having the other surface 2y facing upwards (facing the laser beam output unit 41A, 41B) (see FIG. 8(b)).

As illustrated in FIGS. 3 and 4, the table reversing mechanism 16 rotatably supports two facing sides of the rectangular cutting table 2A, 2B. In this example, the table reversing mechanism 16 rotatably supports the longitudinal ends of the cutting table 2A, 2B. In this manner, it is possible to reduce the size of the space traversed by the cutting table 2A, 2B when the cutting table 2A, 2B is turned over. The cutting table 2A, 2B is also configured to be detachable from the table reversing mechanism 16, so that the cutting table 2A, 2B can be replaced to a special cutting table 2A, 2B depending on the shape of the sealed substrate W.

Specifically, the table reversing mechanism 16 includes two rotation shafts 161a, 161b that are provided at the respective longitudinal ends of the cutting tables 2A, 2B, a base member 162 that rotatably supports the rotation shafts 161a, 161b via bearings such as rolling bearings, and a rotation drive unit 163 such as a motor or a rotary cylinder that is provided to one of the rotation shafts 161a, 161b, and is configured to turn over the cutting table 2A, 2B. The base member 162 has two support walls 162a, 162b that rotatably support the two rotation shafts 161a, 161b, respectively, and a bottom wall 162c on which the two support walls 162a, 162b are provided. In the present embodiment, the one rotation shaft 161a is rotatably supported by the support wall 162a via the rotation drive unit 163.

The two rotation shafts 161a, 161b are provided, in a plan view, at the centers of the respective ends of the cutting tables 2A, 2B in the longitudinal direction. The two rotation shafts 161a, 161b have their centers of rotations on the same straight line, and extend in the horizontal direction. These two rotation shafts 161a, 161b extend in the longitudinal direction of the cutting tables 2A, 2B. Furthermore, at least one of the two rotation shafts 161a, 161b is provided with an internal channel 161R that communicates with the suction channel 2R formed inside the cutting tables 2A, 2B, as illustrated in FIG. 4, and the internal channel 161R is connected to a vacuum pump, not illustrated.

Note that the rotation center of the rotation shafts 161a, 161b may be matched with the center of the cutting table 2A, 2B, or with the center of the sealed substrate W being suctioned to the cutting tables 2A, 2B. With such a configuration, it is possible to reduce a change in the position of the sealed substrate W in the height direction, between before and after the sealed substrate W is turned over, so that it is possible to eliminate or to simplify adjustments of the relative position of the sealed substrate W with respect to the laser beam output units 41A, 41B.

### <Through openings 2T on cutting table 2A, 2B>

In the present embodiment, as illustrated in FIGS. 3 to 8, each of the cutting tables 2A, 2B is provided with a plurality of through openings 2T allowing the laser beam to pass through, in a manner penetrating from one surface 2x, where the suction holes 2h are provided, to the other surface 2y, which is on the back side of the one surface 2x. In these through openings 2T, the laser beam output from the laser beam output units 41A, 41B of the cutting mechanism 4 cuts the sealed substrate W.

As illustrated in FIG. 5, the through openings 2T are provided in plurality, at positions not overlapping with the plurality of suction holes 2h, nor with the suction channel 2R (specifically, the grooves 201M on the base plate 201) communicating with the plurality of suction holes 2h, in a plan view of the cutting table 2A, 2B, that is, in a view of the cutting table 2A, 2B from the side of the one surface 2x.

The plurality of through openings 2T are provided at positions corresponding to the cut lines CL1, CL2 (see FIG. 1) of the sealed substrate W, and are provided so as to include the cut lines CL1, CL2 in the plan view of the cutting table 2A, 2B. Specifically, each of the through openings 2T is longer than the length of each of the cut lines CL1, CL2 in the cutting direction (machining direction), and has a width greater than the kerf width to be removed between the packages. The through opening 2T also has such an opening size that the cutting table 2A, 2B is not irradiated with the laser beam emitted from the laser beam output units 41A, 41B.

In the present embodiment, because the cut lines CL1 on the strips W1 at the odd-numbered columns are aligned along the lines that are offset from the cut lines CL2 on the strips W2 at the even-numbered columns on the sealed substrate W, as illustrated in FIG. 2, the plurality of through openings 2T formed on the cutting tables 2A, 2B are aligned on the different straight lines, in the same manner, that is, the through openings 2T corresponding to the cut lines CL1 on the strips W1 in the odd-numbered columns are also aligned along the lines that are offset from the lines along which the through openings 2T corresponding to the cut lines CL2 on the strips W2 in the even-numbered columns are aligned (see FIG. 5).

As illustrated in FIGS. 7 and 8, each of the through openings 2T has a shape that gradually becoming larger from the one surface 2x, where the suction holes 2h are provided, toward the other surface 2y. Specifically, the through opening 2T has a shape that becoming larger from the one surface 2x toward the other surface 2y, in a cross section orthogonal to the direction in which the laser beam is scanned. Note that the through opening 2T may have any cross-sectional shape as long as irradiation with the laser beam is avoided; the through opening 2T may have a cross-sectional shape remaining constant, or may have a shape becoming larger stepwisely, from the one surface 2x toward the other surface 2y.

Further provided in the present embodiment is a position changing mechanism 17 for changing the relative position between the cutting table 2A, 2B and the laser beam output units 41A, 41B before and after the cutting table 2A, 2B is turned over, because the height position of the sealed substrate W changes, as illustrated in FIG. 8, when the cutting table 2A, 2B is turned over. The position changing mechanism 17 changes the relative positions of the cutting table 2A, 2B and the laser beam output units 41A, 41B to adjust the focal position of the laser beam to the sealed substrate W.

The position changing mechanism 17 may be provided in the machining head actuator mechanism 11 that moves the machining head 40 (see FIG. 2), and may be configured to change the height positions of the machining head 40 (laser beam output units 41A, 41B) before and after the cutting tables 2A, 2B are turned over. The position changing mechanism 17 may also be implemented using the machining head actuator mechanism 11. Note that the height positions of the cutting table 2A, 2B may be changed so that the height position remains the same before and after the cutting table 2A, 2B is turned over.

### <Swarf container 18>

As illustrated in FIGS. 3, 4, and 8(c), the cutting apparatus 100 according to this embodiment further includes a swarf container 18 that stores therein swarf S, such as waste material discharged by cutting the sealed substrate W. The swarf container 18 is provided below the cutting table 2A, 2B. Specifically, the swarf container 18 is provided between the two support walls 162a, 162b of the base member 162 that supports the cutting table 2A, 2B. The swarf container 18 is configured to be detachable from the base member 162, and removable from the base member 162 so that the swarf S can be disposed outside the cutting apparatus 100.

When the distance between the machining head 40 and the swarf container 18 is short, the energy density of the laser beam having passed through the through opening 2T may be still high, and the laser beam may scatter on the bottom surface of the swarf container 18. In order to suppress such scattering, a highly absorbable surface treatment may be applied to the bottom surface of the swarf container 18, or an absorber may be provided on the bottom surface of the swarf container 18.

### <Swarf removing mechanism 19>

The cutting apparatus 100 according to this embodiment also includes a swarf removing mechanism 19 that removes swarf S such as an unwanted material remaining on the sealed substrate W cut with a laser beam, as illustrated in FIG. 8(c).

The swarf removing mechanism 19 includes a gas spraying unit 191 that blows gas such as compressed air toward the sealed substrate W, and is configured to remove the swarf S using the gas sprayed from the gas spraying unit 191. The gas spraying unit 191 is provided above the cutting table 2A, 2B, and is configured to remove the swarf S by blowing the gas toward the cutting table 2A, 2B from above. With this configuration, the gas sprayed from the gas spraying unit 191 passes through the through opening 2T, and is blown against the remaining swarf S. Because the gas goes through the through opening 2T, it is possible to blow the swarf S at high intensity, while increasing the flow velocity of the gas. The removed swarf S is collected in the swarf container 18 provided below the cutting table 2A, 2B. The swarf removing mechanism 19 may also be configured to remove the swarf S by blowing gas from above to the cutting table 2A, 2B before being turned over.

In addition to the configuration in which the gas is blown against the remaining swarf S as described above, the swarf removing mechanism 19 may also be configured to be physically brought into contact with the remaining swarf S and shove off the remaining swarf S. In this case, the swarf removing mechanism 19 includes a pushing member such as a pin that pushes the swarf S, and the swarf removing mechanism 19 shoves the swarf S off into the swarf container 18 by moving the pushing member up and down respect to the cutting table 2A, 2B.

### <First inspection unit 13>

In this embodiment, the first inspection unit 13 is provided, as illustrated in FIG. 2. The first inspection unit 13 captures an image of a plurality of products P cut by the cutting mechanism 4 from the front-surface side, and inspects the products P.

The first inspection unit 13 captures an image of the front surfaces of the plurality of respective products P from above the cutting tables 2A, 2B. When the products P are to be inspected by the first inspection unit 13, the cutting tables 2A, 2B is kept without being turned over.

Specifically, the first inspection unit 13 includes a first camera 131 having an optical system for capturing an image of the front surfaces of the plurality of respective products P being suctioned on the cutting tables 2A, 2B. The first camera 131 is provided between the transfer shaft 71 and the cutting mechanism 4 in a manner enabled to be moved in the X direction by a camera actuator mechanism 132. It is preferable for the first camera 131 to be specified with a high shutter speed and a short exposure time.

The camera actuator mechanism 132 according to this embodiment enables the first camera 131 to move between the two cutting tables 2A, 2B. To capture an image of the plurality of products P being suctioned on one cutting table 2A with the first camera 131, the camera actuator mechanism 132 moves the first camera 131 above the cutting table 2A. By this time, the cutting table 2A has been moved, by the cutting actuator mechanism 8A, in the Y direction and to a predetermined inspection position. To capture an image of the plurality of products P being suctioned on the other cutting table 2B with the first camera 131, the camera actuator mechanism 132 moves the first camera 131 above the cutting table 2B. By this time, the cutting table 2B has already been moved, by the cutting actuator mechanism 8B, in the Y direction and to a predetermined inspection position.

The camera actuator mechanism 132 then moves the first camera 131 in the X direction above the cutting table 2A, 2B, and the first camera 131 captures an image of the front surfaces (mounting surfaces) of the respective products P being suctioned on the cutting table 2A, 2B.

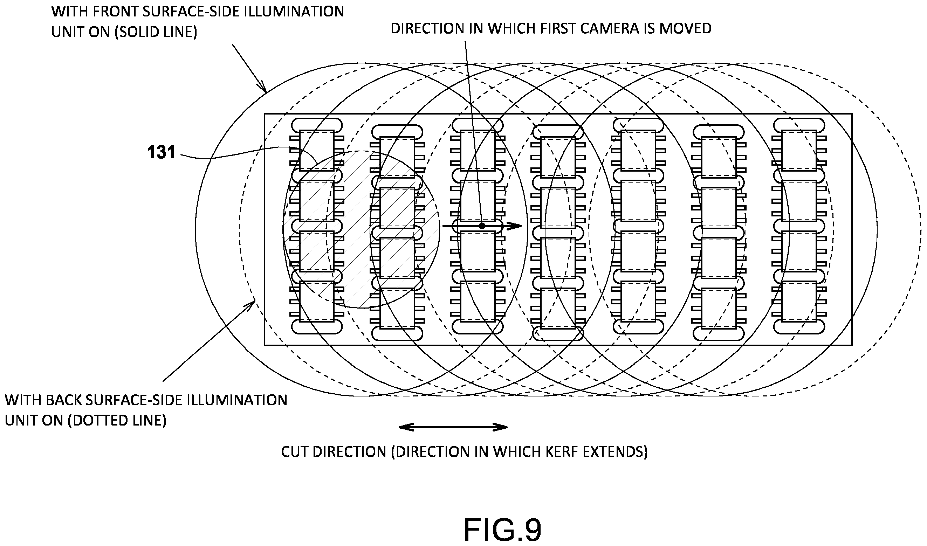

Specifically, as illustrated in FIG. 9, the camera actuator mechanism 132 moves the first camera 131 relatively with respect to the cutting table 2A, 2B, along the cut direction having been cut by the cutting mechanism 4 (the direction in which the kerf extends). At this time, the cutting table 2A, 2B has already been rotated by the rotating mechanism 9A, 9B in such a manner that the cut direction having been cut by the cutting mechanism 4 (the direction in which the kerf extends) is in parallel with the X direction.

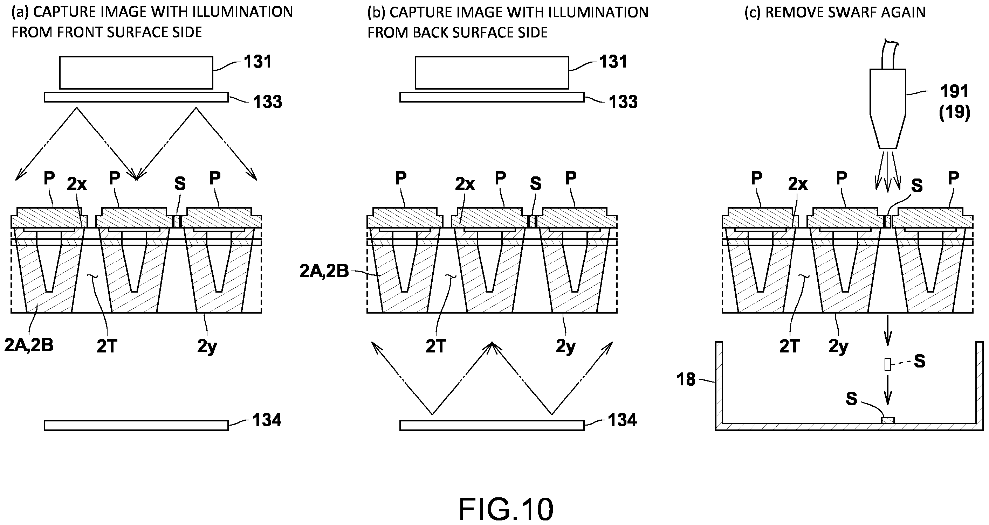

Furthermore, a front-surface side illumination unit 133 and a back-surface side illumination unit 134 are also provided in this embodiment, as illustrated in FIG. 10. The front-surface side illumination unit 133 is provided on the same side as the first camera 131 with respect to the cutting table 2A, 2B, and illuminates the front-surface side of the plurality of products P. The back-surface side illumination unit 134 is provided on the opposite side of the first camera 131 with respect to the cutting table 2A, 2B, and generates transmitting light that passes through the through openings 2T to illuminate the back-surface side of the plurality of respective products P, through the through openings 2T.

Each of the front-surface side illumination unit 133 and the back-surface side illumination unit 134 is an illumination apparatus that emits strobe light, and, in the embodiment, a xenon lamp is used, as an example. The front-surface side illumination unit 133 may be provided integrally with or separately from the first camera 131. The back-surface side illumination unit 134 is movably provided below the cutting table 2A, 2B that is at the predetermined inspection position.

The front-surface side illumination unit 133 and the back-surface side illumination unit 134 are then turned on alternately, while moving the first camera 131 relatively with respect to the cutting table 2A, 2B, as illustrated in FIG. 9. Every time the front-surface side illumination unit 133 or the back-surface side illumination unit 134 is turned on, the first camera 131 captures an image of the plurality of products P being suctioned on the cutting table 2A, 2B. In this manner, the first camera 131 captures images of the plurality of products P illuminated from the front-surface side, and those of the plurality of products P illuminated from the back-surface side, successively.

Each of the images captured by the first camera 131 is subjected to image processing performed by an image processing unit implemented by the control unit CTL, and measurements of the appearance such as the measurement of a kerf width between the products P are collected and inspected, to make determinations such as whether each of the products P is a non-defective product or a defective product. The image captured by illuminating the products P from the front-surface side is used for an appearance inspection of the front surface (mounting surface) of the product P, or for measuring the dimensions of the edge portions of the kerf formed between the products P on the front-surface side of the products P, for example. The image captured by illuminating the products P from the back-surface side is used for inspecting for the presence of swarf, such as waste material remaining between the products P, or to measure the minimum width of the kerf between the products P, for example.

### <Second inspection unit 14>

Furthermore, as illustrated in FIG. 2, the cutting apparatus 100 according to this embodiment includes a second inspection unit 14 that inspects the back surfaces (mark surfaces) of the plurality of respective products P being transported by being held by the second pickup mechanism 6. The second inspection unit 14 includes a second camera 141 having an optical system for capturing an image of the back surfaces (mark surfaces) of the plurality of respective products P, the back surfaces being the suctioned surfaces. Each of the images captured by the second camera 141 is subjected to image processing performed by the image processing unit implemented by the control unit CTL, to inspect the mark surfaces of the respective products P and to make determinations such as whether each of the products P is a non-defective product or a defective product.

### <One example of operation of cutting apparatus 100>

An example of the operation of the cutting apparatus 100 will now be explained. In this embodiment, the control unit CTL (see FIG. 2) is responsible for all operations and controls of the operations of the cutting apparatus 100, such as transportation of the sealed substrate W, cutting of the sealed substrate W, removal of swarf S, inspections of the products P, and housing of the products P in the trays.

The substrate feeder unit 10b in the substrate feeder mechanism 10 feeds the sealed substrate W housed inside the substrate housing 10a to the pickup position RP, where the first pickup mechanism 3 picks up the sealed substrate W.

The transport actuator mechanism 7 moves the first pickup mechanism 3 to the pickup position RP, and the first pickup mechanism 3 picks up the sealed substrate W by suctioning. The transport actuator mechanism 7 then moves the first pickup mechanism 3 holding the sealed substrate W to the cutting table 2A, 2B, and the first pickup mechanism 3 releases the sealed substrate W being held by suctioning, to place the sealed substrate W on the cutting tables 2A, 2B. The cutting table 2A, 2B then suctions to hold the sealed substrate W.

With the sealed substrate W suctioned, the cutting actuator mechanism 8A, 8B moves the cutting table 2A, 2B, to a predetermined cutting position (behind the transfer shaft 71). At this cutting position, the cutting tables 2A, 2B and the two laser beam output units 41A, 41B are moved in the X direction and the Y direction, by the cutting actuator mechanism 8A, 8B and the machining head actuator mechanism 11, respectively, whereby cutting and dicing the sealed substrate W. Note that the cutting table 2A, 2B is rotated by the rotating mechanism 9A, 9B, as required.

A specific cutting method will now be explained.

To begin with, after the sealed substrate W is suctioned and held on the cutting table 2A, 2B, the sealed substrate W and the laser beam output unit 41A, 41B are aligned (have their positions adjusted) with respect to each other. This alignment is achieved by using imaging data acquired by causing an alignment camera 20 to capture an image of alignment marks on the sealed substrate W.

The surface of the sealed substrate W is then irradiated with the laser beam from the laser beam output unit 41A, 41B, as illustrated in FIG. 8(a), and the sealed substrate W is partly cut and grooved (half-cut), without causing the table reversing mechanism 16 to reverse the cutting tables 2A, 2B. FIG. 8(a) illustrates an example in which two grooves are cut between the packages in order to match the kerf width achieved by blade cutting.

After the grooving, the table reversing mechanism 16 turns over the cutting table 2A, 2B, as illustrated in FIG. 8(b). After the cutting table 2A, 2B is reversed, no alignment (positional adjustment) is performed, and the imaging data obtained before the reversal of the cutting table 2A, 2B is used, by inverting the imaging data with respect to the rotation axis of the rotation shafts 161a, 161b. If the height position of the sealed substrate W has changed as a result of reversing the cutting table 2A, 2B, the position changing mechanism 17 adjusts the focal position of the laser beam onto the sealed substrate W, by changing the relative position between the cutting table 2A, 2B and the laser beam output unit 41A, 41B. The back surface of the sealed substrate W is then irradiated with a laser beam output from the laser beam output units 41A, 41B and passed through the through openings 2T, to cut the grooved portion grooved by half-cutting completely (full cut). The swarf S such as the unwanted material resultant of the full cut falls into and is collected into the swarf container 18.

Before the laser beam output unit 41A, 41B is moved to a different cut line CL1, CL2 during the half cutting or the full cutting, the laser beam output unit 41A, 41B stop outputting the laser beam. The table reversing mechanism 16 may also repeat reversing the cutting table 2A, 2B a plurality of number of times in accordance with the type of the sealed substrate W, the cutting process, and the like.

After the cutting described above, as illustrated in FIG. 8(c), the gas spraying unit 191 of the swarf removing mechanism 19 is moved above the cutting table 2A, 2B, and blows the gas against the turned over cutting table 2A, 2B from above, to remove the swarf S. The swarf S removed by the swarf removing mechanism 19 falls and is collected into the swarf container 18. Before the swarf removing mechanism 19 is moved above the cutting tables 2A, 2B, the machining head actuator mechanism 11 may evacuate the laser beam output units 41A, 41B to the positions that do not interfere with the swarf removing mechanism 19.

After the swarf S is removed, the cutting actuator mechanism 8A, 8B moves the cutting table 2A, 2B to the predetermined inspection position. At this time, the cutting table 2A, 2B is kept without being turned over by the table reversing mechanism 16. The camera actuator mechanism 132 then moves the first camera 131 of the first inspection unit 13 in the X direction, and the first camera 131 captures images of the plurality of products P being suctioned on the cutting table 2A, 2B. While the camera actuator mechanism 132 moves the first camera in the X direction, the front-surface side illumination unit 133 and the back-surface side illumination unit 134 are alternately turned on, and the first camera captures an image of the plurality of products P at the timing at which each of the illumination units 133, 134 is turned on, as illustrated in FIGS. 9 and 10. Each of the images captured by the first camera 131 is then sent to the image processing unit in the control unit CTL, and the image processing unit makes the determinations such as whether each of the products P is a non-defective product or a defective product. When the first inspection unit 13 detects that there are still some swarf S remaining between the products P, the gas spraying unit 191 in the swarf removing mechanism 19 described above may be enabled to remove the swarf S again (see FIG. 10(c)).

After the swarf S is removed and the front surfaces of the respective products P are inspected, the cutting actuator mechanism 8A, 8B moves the cutting table 2A, 2B to a predetermined transfer position (in front of the transfer shaft 71).

The transport actuator mechanism 7 then moves the second pickup mechanism 6 to the cutting table 2A, 2B for which the cutting has finished. The second pickup mechanism 6 then suctions the plurality of products P.

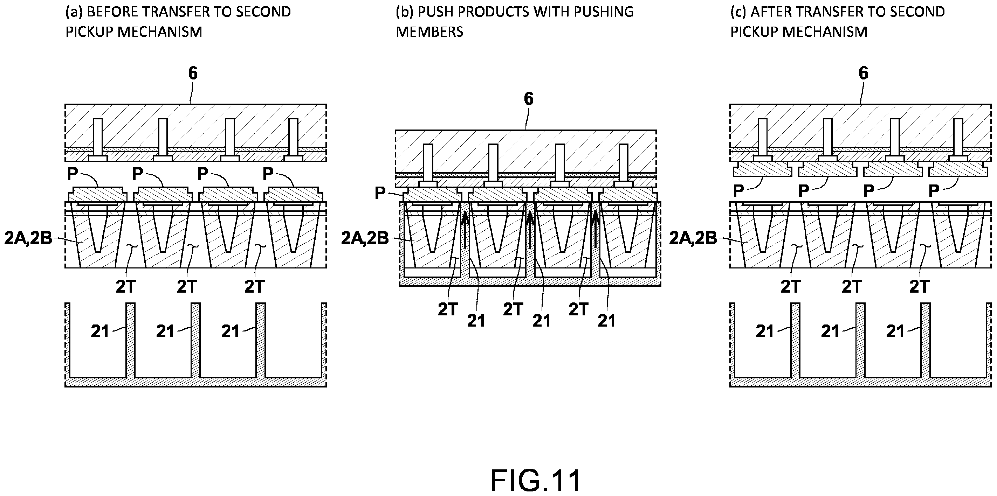

When the plurality of products P are to be transferred from the cutting table 2A, 2B to the second pickup mechanism 6, the products P may stick to the cutting table 2A, 2B and fail to be transferred reliably to the second pickup mechanism 6. To address this issue, as illustrated in FIG. 11, it is possible to use pushing members 21, such as pins, for pushing up the back surfaces of the respective products P, through the respective through openings 2T of the cutting table 2A, 2B. The pushing members 21 push up the plurality of respective products P toward the second pickup mechanism 6, through the through openings 2T, respectively, while the second pickup mechanism 6 is in contact with or near the plurality of products P being suctioned on the cutting table 2A, 2B (see FIG. 11(b)). With this, the plurality of products P are transferred from the cutting tables 2A, 2B to the second pickup mechanism 6, reliably (see FIG. 11(c)).

The transport actuator mechanism 7 then moves the second pickup mechanism 6 holding the plurality of products P to the transfer table 5. During the transportation of the plurality of products P to the transfer table 5, the bottom surfaces (mark surfaces) of the plurality of respective products P being held by the second pickup mechanism 6 is inspected using the second camera 141 of the second inspection unit 14.

After the inspection, the transport actuator mechanism 7 transfers the plurality of products P onto the transfer table 5. The transfer table 5 having the products P placed thereon is moved to the pickup position X2 by the transfer actuator mechanism 12. The sorting mechanism 15a then sorts the plurality of products P from the transfer table 5 onto the various trays T, based on the results of the inspections carried out by the first inspection unit 13 and the second inspection unit 14 (e.g., non-defective products and defective products).

### <Advantageous effects achieved by embodiment>

With the cutting apparatus 100 according to this embodiment, because the first camera 131 captures an image of the plurality of products P being suctioned on the cutting tables 2A, 2B, it is not necessary to transfer the products P to a separate inspection table, so that the cutting apparatus 100 can be simplified, while improving the productivity. In addition, because the inspections are performed while moving the first camera 131 relatively with respect to the cutting table 2A, 2B, it is possible to reduce the number of stops, accelerations, and decelerations of the cutting tables 2A, 2B, and to shorten the inspection time. Furthermore, because the cutting apparatus 100 can be simplified, it is possible to reduce the footprint.

Moreover, by turning over the cutting table 2A, 2B with the sealed substrate W suctioned thereto, the sealed substrate W can be cut from both sides of the sealed substrate W. Therefore, it is possible to reduce the cutting time, and to improve the productivity.

Furthermore, by collecting a measurement of the amount of the positional shift resultant of turning over the cutting tables 2A, 2B once in advance, it becomes possible to correct the position after the reversal, through calculation. Therefore, it is not necessary to make the alignment (adjust the position) every time a workpiece is turned over. Therefore, the alignment (positional adjustment) of the laser beam output units 41A, 41B with respect to the sealed substrate W is required only once after the sealed substrate W is suctioned.

Still furthermore, because the cutting tables 2A, 2B are provided with the plurality of through openings 2T through which the laser beam is allowed to pass, when the part of the sealed substrate W corresponding to the through opening 2T is cut by being irradiated with the laser beam, the laser beam passes through the through opening 2T so that the laser beam does not hit the cutting tables 2A, 2B. As a result, it is possible to suppress damages of the cutting tables 2A, 2B due to being irradiated with a laser beam, to lessen the contaminants (impurities, foreign matters) becoming adhered to the sealed substrate W due to the damages, and to alleviate the restrictions imposed on the laser processing conditions for preventing damages of the cutting tables 2A, 2B. Because the restrictions imposed on the laser machining conditions can be alleviated, it becomes possible to use higher pulse energy and average output. Therefore, it is possible to shorten the machining time and to improve productivity, advantageously.

In addition, because the laser beam passes through the through opening 2T, it is possible to prevent the sealed substrate W from being irradiated with the laser beam reflected on the cutting table 2A, 2B, and to prevent damages of the sealed substrate W caused by the laser beam reflected on the cutting table 2A, 2B.

In addition, because the through opening 2T becomes larger toward the other surface 2y, the laser beam emitted from the one surface 2x and passed through the sealed substrate W does not hit the inner surface of the through opening 2T. In addition, even when the cutting table 2A, 2B is turned over and the laser beam is emitted from the side of the other surface 2y, the laser beam does not hit the inner surface of the through opening 2T, either. As a result, it is possible not only to suppress the damages of the cutting tables 2A, 2B caused by the laser beam hitting the cutting tables 2A, 2B, but also to prevent deterioration of the quality of the sealed substrate W, caused by the reflected laser beam hitting an unintended area of the sealed substrate

### W.

### <Other modifications>

Note that the present invention is not limited to the embodiment described above.

Although the cutting apparatus according to the embodiment described above is configured to store the products P on the trays, the present invention may be also configured to use storages such those described below, without limitation to the storage using trays.

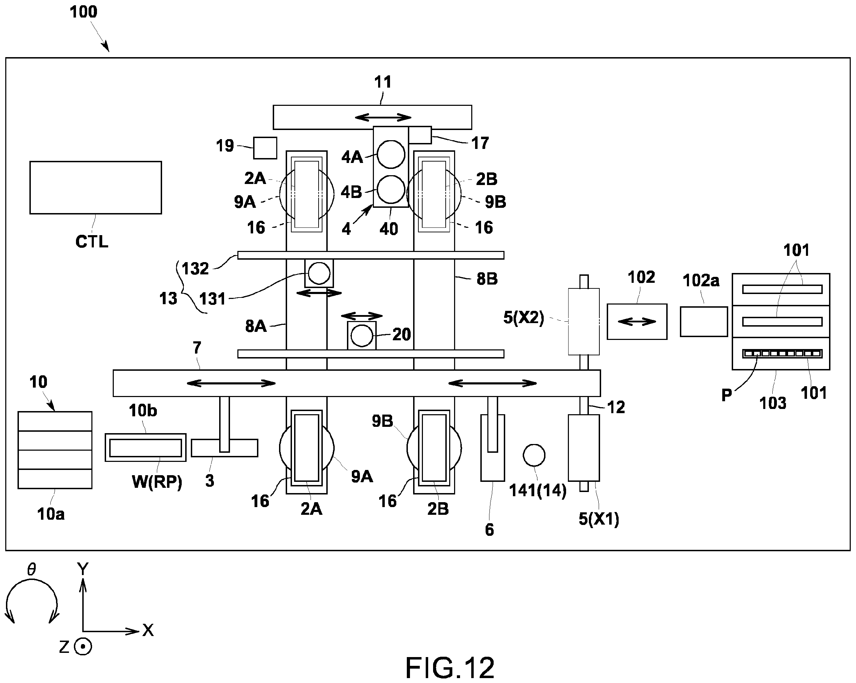

The cutting apparatus 100 may also be configured to store the plurality of products P in a tubular container 101 (also referred to as "tube storage"), as illustrated in FIG. 12. The tubular container 101 is also sometimes referred to as a tube, a magazine stick, a stick magazine, or a stick, for example.

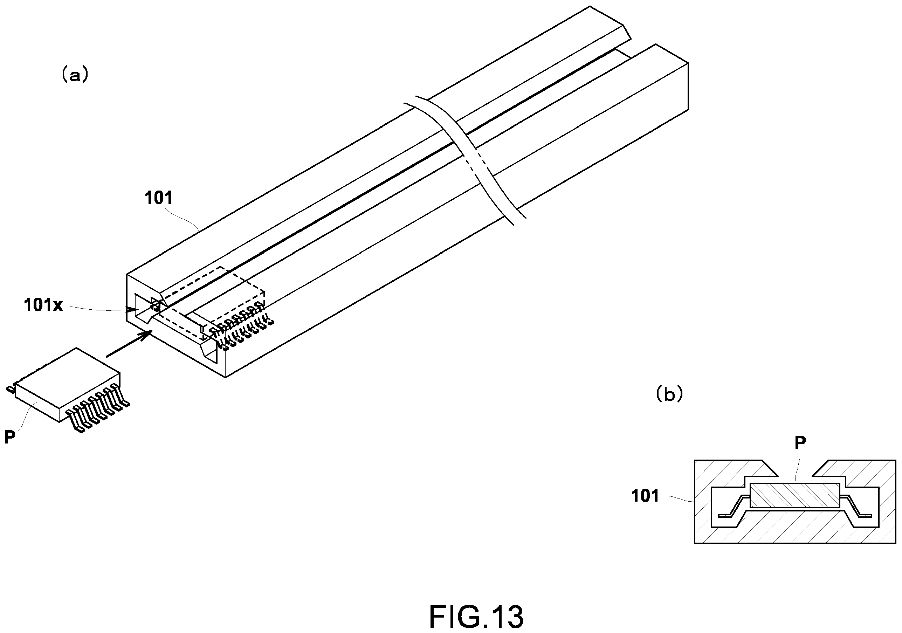

Specifically, the tubular container 101 stores therein a plurality of products P in a manner lined up in a row, as illustrated in FIG. 13. Specifically, the tubular container 101 has a shape extending linearly, and has a space in which the products P are stored. The tubular container 101 has a cross-sectional shape corresponding to the cross-sectional shape of the products P, in the direction orthogonal to the longitudinal direction. The products P are inserted into the tubular container 101 through the one end opening 101x by a transport and storage mechanism 102. Although the tubular container 101 illustrated in FIG. 13 has an opening on a part of a side wall extending along the longitudinal direction, but this side wall may also be closed. In addition to the configuration in which the plurality of products P are stored in a manner lined up in one row, the tubular container 101 may also be configured to store the plurality of products P in a manner lined up in a plurality of rows. The tubular container 101 may be made of resin or metal. In addition, although FIG. 13 illustrates an example in the products P are leaded packages, but the products P may be leadless packages such as QFN packages.

In such a case, the plurality of products P are temporarily placed on the transfer table 5 before being stored in the tubular container 101. The transfer table 5 is then moved, by the transfer actuator mechanism 12, between the transfer position X1 where the plurality of products P are placed by the second pickup mechanism 6, and the pickup position X2 where the plurality of products P are transported by the transport and storage mechanism 102.

The transport and storage mechanism 102 then stores the plurality of products P having been placed on the transfer table 5 into the tubular containers 101, based on the result of the inspections carried out by the first inspection unit 13 and the second inspection unit 14 (e.g., non-defective products and defective products). The tubular container 101 is placed on a container setting part 103. Note that the container setting part 103 in FIG. 12 includes a part for storing an empty tubular container 101, a part for placing an empty tubular container 101 into which the products P are to be inserted from the one end opening 101x, and a part for storing the tubular container 101 filled with the products P or storing therein a predetermined number of the products P. The transport and storage mechanism 102 transports a plurality of products P from the transfer table 5 at the pickup position X2 to an intermediate table 102a, and transports the products P from the intermediate table 102a and stores the products P in the tubular container 101.

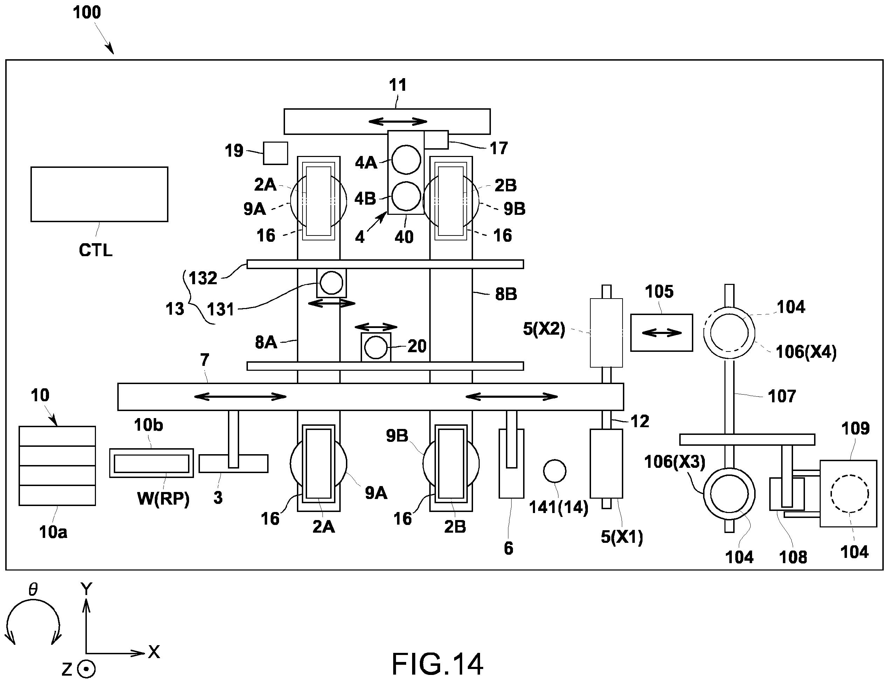

As another example, the cutting apparatus 100 may be configured to store a plurality of products P in a manner bonded to a bonding member 104 having an adhesive surface 104x (also referred to as a "ring storage"), as illustrated in FIG. 14.

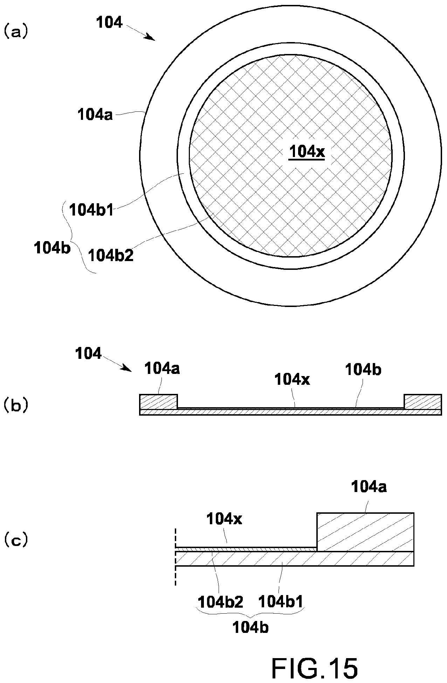

Specifically, as illustrated in FIG. 15, the bonding member includes, for example, a frame-like member 104a having an annular or rectangular shape, and a resin sheet 104b having the adhesive surface 104x and disposed inside the frame-like member 104a. The frame-like member 104a is made of metal such as stainless steel. The resin sheet 104b includes, for example, a sheet-like substrate 104b1 made of resin and an adhesive layer (adhesion layer) 104b2 made of an adhesive having been applied to the upper surface of the sheet-shaped substrate 104b1. The upper surface of the adhesive layer (adhesion layer) 104b2 serves as the adhesive surface 104x.

In this case, the plurality of products P are temporarily placed on the transfer table 5 before the plurality of products P are bonded to the bonding member 104. The transfer table 5 is then moved, by the transfer actuator mechanism 12, between the transfer position X1 where the plurality of products P are placed by the second pickup mechanism 6, and the pickup position X2 where the plurality of products P are transported by a bonding transport mechanism 105.

The bonding transport mechanism 105 then bonds the plurality of products P having been placed on the transfer table 5, onto the bonding member 104, based on the result of the inspections carried out by the first inspection unit 13 and the second inspection unit 14 (e.g., non-defective products and defective products). The bonding member 104 is on the placement table 106. The placement table 106 is provided in a manner movable in the Y direction, as illustrated in FIG. 14. A placing actuator mechanism 107 then moves the placement table 106 between a bonding member transport position X3 to which the bonding member transport mechanism 108 transports the bonding member 104 and a bonding position X4 to which the bonding transport mechanism 105 transports the plurality of products P. The bonding member transport mechanism 108 also transports the bonding member 104 between the placement table 106 at the bonding member transport position X3 and a bonding member storage 109 that stores the bonding member 104. The bonding member transport mechanism 108 holds the bonding member 104 by suctioning the frame-like member 104a of the bonding member 104.

In the embodiment described above, the second inspection unit 14 is provided, but the second inspection unit 14 may be omitted. In such a case, the first inspection unit 13 makes the determinations such as whether each of the plurality of products P is a non-defective product or a defective products during its inspection, and the products P are put into the tray storage, tube storage, or ring storage, accordingly.

In the embodiment described above, the first camera 131 captures the images of the plurality of products P being suctioned on the cutting table 2A, 2B while causing the camera actuator mechanism 132 to move the first camera 131 in the cutting direction (X direction), but it is also possible to capture the images of the plurality of products P being suctioned to the cutting table 2A, 2B while causing the cutting actuator mechanism 8A, 8B to move the cutting table 2A, 2B in the Y direction. Furthermore, it is also possible to capture the images of the plurality of products P suctioned on the cutting table 2A, 2B while causing the camera actuator mechanism 132 to move the first camera 131 and causing the cutting actuator mechanism 8A, 8B to move the cutting table 2A, 2B, simultaneously.

In the embodiment described above, the first camera 131 is shared between the two cutting tables 2A, 2B, but may also be provided for each of the cutting tables 2A, 2B.

In the embodiment described above, the products P are inspected by moving the cutting table 2A, 2B from the cutting position to the inspection position, but it is also possible to inspect the products P at the cutting position. In such a case, after the laser beam output unit 41A, 41B in the cutting mechanism 4 completes cutting, the laser beam output units 41A, 41B may be retracted, and the first camera 131 may be moved above the cutting table 2A, 2B.

Furthermore, in the embodiment described above, when the first camera 131 captures the images of the products P, the cutting table 2A, 2B is kept without being turned over; however, it is also possible to turn over the cutting table 2A, 2B. Furthermore, the images of the products P may be captured before and after the cutting tables 2A, 2B are turned over.

The two cutting tables 2A, 2B according to the embodiment described above have the plurality of through openings 2T at the same respective positions. However, the plurality of cutting tables 2A, 2B may have the plurality of through openings 2T at different positions. With this configuration, it is possible to machine the sealed substrate W with a laser beam on one cutting table 2A, and then to reload the sealed substrate W onto the other cutting table 2B, to have the sealed substrate W machined at another positions. Furthermore, it becomes possible to implement a configuration in which two types of sealed substrates having different product layouts are subjected to laser processing using the two cutting tables, respectively.

The two cutting tables 2A, 2B according to the embodiment described above may be three or more, in order to balance out the time required in the respective processes.

In addition, the rotating mechanism of the cutting table 2A, 2B may be omitted, and the laser beam output unit may be rotated so that the position machined thereby is rotated. In such a case, when the first camera 131 is moved relatively with respect to the cutting table 2A, 2B for inspection, the cut direction having been cut by the cutting mechanism 4 (the direction in which the kerf extends) may be kept in parallel with the Y direction, without rotating the cutting table 2A, 2B.

The cutting apparatus 100 according to the embodiment described above cuts the sealed substrate W by turning over the cutting table 2A, 2B; however, depending on the type of the sealed substrate W, for example, the sealed substrate W may be cut only from the front side without turning over the cutting tables 2A, 2B, or the sealed substrate W may be cut only from the back side by turning over the cutting tables 2A, 2B.

On the sealed substrates W according to the embodiment described above, the cut lines CL1 on the strip W1 are aligned along the lines that are different from those that the cut lines CL2 on the strip W2 are aligned, the strip W2 being adjacent to the strip W1. However, the cut lines CL1 and CL2 may also be aligned along the same straight lines. In this case, the plurality of through openings 2T provided to the cutting tables 2A, 2B are aligned along the same lines corresponding to the respective cut lines CL1, CL2. At this time, a plurality of through openings 2T provided on the same single line may be integrated into one through opening.

The cutting mechanism 4 according to the embodiment described above is configured to cut using a laser beam, but may be configured to cut using a blade.

Described above in the embodiment is an example of a cutting apparatus using a twin-cutting table structure including two cutting tables, and a twin-laser configuration including two laser beam output units; however, the present invention is not limited thereto, and the cutting apparatus may also have a single-cutting table structure including one cutting table and a single-laser configuration including one laser beam output unit, or a single-cut table structure including one cutting table and a twin-laser configuration including two laser beam output units, for example.

In FIGS. 7 and 8 according to the embodiment described above, every through opening 2T has a shape becoming larger from one surface 2x toward the other surface 2y, across the entire cutting tables (machining tables) 2A, 2B. However, the present invention is not limited thereto, and at least a part of the through opening 2T may have a shape that becomes larger from the one surface 2x toward the other surface 2y. For example, the base plate 201, which is at the lowermost position before the cutting table 2A, 2B is turned over, may have the through openings 2T each having a shape becoming larger from one surface toward the other surface.

In addition, in the embodiment described above, the machining for half cutting and full cutting has been explained; however, it is also possible to switch the machining conditions, so that laser marking is performed additionally.

Furthermore, the cutting apparatus according to the present invention may perform machining other than cutting, and for example, may perform other types of machining such as milling and grinding.

In addition, the present invention is not limited to the embodiment described above, and it should be needless to say that various modifications may be made within the scope not departing from the gist of the present invention.

### Industrial Applicability

According to the present invention, it is possible to simplify a machining apparatus and to improve the productivity by capturing an image of a workpiece having been machined and inspecting the workpiece having been machined while the workpiece is being suctioned onto the machining table.

### Reference Signs List

- 100: cutting apparatus (machining apparatus)
- W: sealed substrate (workpiece)
- P: product (machined article)
- 2A, 2B: cutting table (machining table)
- 2h: suction hole
- 2x: one surface
- 2y: other surface
- 3: first pickup mechanism (transport mechanism)
- 41A, 41B: laser beam output unit
- 7: transport actuator mechanism (transport mechanism)
- 17: position changing mechanism
- 18: swarf container
- 19: swarf removing mechanism

## Claims

1. A machining apparatus comprising:
a machining table having one surface provided with a plurality of suction holes enabled to suction a workpiece;
a machining mechanism that machines the workpiece being suctioned onto the machining table; and
a first camera that captures an image of the workpiece having been machined by the machining mechanism, wherein
the machining table has a plurality of through openings penetrating the machining table from the one surface to another surface,
the machining mechanism machines the workpiece in each of the through openings, and
the first camera captures an image of the workpiece having been machined while the workpiece is being suctioned on the machining table.

2. The machining apparatus according to claim 1, further comprising an actuator mechanism that moves the first camera and the machining table relatively with respect to each other in order to enable the first camera to capture an image of the workpiece having been machined while the workpiece is being suctioned on the machining table.

3. The machining apparatus according to claim 2, wherein the actuator mechanism moves the first camera and the machining table relatively to each other along a direction along which the machining mechanism performs machining.

4. The machining apparatus according to any one of claims 1 to 3, further comprising a back-surface side illumination unit that is provided on the opposite side of the first camera with respect to the machining table, and generates transmitting light that is to pass through the through openings.

5. The machining apparatus according to claim 4, further comprising a front-surface side illumination unit that is provided on a same side as the first camera with respect to the machining table, and illuminates the machined workpiece, wherein
the first camera captures an image of the workpiece while turning on the front-surface side illumination unit and the back-surface side illumination unit alternately.

6. The machining apparatus according to any one of claims 1 to 5, further comprising a swarf removing mechanism that removes swarf remaining on the workpiece having been machined.

7. The machining apparatus according to any one of claims 1 to 6, further comprising:
a transport mechanism that transports the workpiece having been machined, by suctioning a surface on an opposite side of a suctioned surface that is suctioned by the machining table; and
a second camera that captures an image of the suctioned surface of the machined workpiece being transported by the transport mechanism.

8. The machining apparatus according to any one of claims 1 to 7, wherein the machining mechanism cuts the workpiece by irradiating the workpiece with a laser beam.

9. The machining apparatus according to claim 8, wherein
the machining table is enabled to be turned over, and
the workpiece is cut from both sides by turning over the machining table holding the workpiece, and by irradiating the workpiece with the laser beam.

10. A method for manufacturing a machined article, the method comprising manufacturing a machined article using the machining apparatus according to any one of claims 1 to 9.

11. The method for manufacturing a machined article according to claim 10, the method comprising:
a cutting step of turning over a machining table holding the workpiece and cutting the workpiece by irradiating both surfaces of the workpiece with a laser beam; and
an inspection step of inspecting the workpiece having been machined, the workpiece being suctioned on the machining table, by causing the first camera to capture an image of the workpiece.
